# EUROPEAN PATENT APPLICATION

(11) **EP 4 538 798 A1**
(43) Date of publication of application: **16.04.2025**
(21) Application number: 23830833.2
(22) Date of filing: 09.05.2023
(51) Int. Cl.: G03F 7/20, H05G 2/00

(54) **DEBRIS REDUCTION DEVICE AND LIGHT SOURCE DEVICE PROVIDED WITH SAME**

(30) Priority: 27.06.2022 JP 2022102501
(71) Applicant: Ushio Denki Kabushiki Kaisha, Tokyo 100-8150 (JP)
(72) Inventor: ASHIZAWA, Noritaka, Tokyo 100-8150 (JP); HIRATA, Hironobu, Tokyo 100-8150 (JP)
(74) Representative: Maiwald GmbH
(86) International application number: PCT/JP2023/017355
(87) International publication number: WO 2024/004381

(57) **Abstract**

[Object] To provide a debris reduction apparatus that enables enhancement of debris-capturing probability and a light source apparatus provided with the same.

[Solving Means] A debris reduction apparatus according to an embodiment of the present technology includes a fixed foil trap. The fixed foil trap includes an enclosure section, a plurality of foils, an inflow hole, and a pressure-increasing mechanism. The enclosure section includes an incident port that light emitted from the light source enters, an emission port from which the light that has entered from the incident port is emitted, and an inner space through which the light travels. The plurality of foils is fixed to a region of the inner space through which the light travels. The inflow hole is configured in the enclosure section to communicate with the inner space and in which transparent gas transparent to the light flows. The pressure-increasing mechanism includes at least one of an incident side member that is disposed in the incident port so that an opening area of the incident port decreases without blocking traveling of the light or an emission side member that is disposed in the emission port so that an opening area of the emission port decreases without blocking traveling of the light, the pressure-increasing mechanism increasing a pressure of the inner space.

## Description

### Technical Field

The present technology relates to a debris reduction apparatus that captures debris and a light source apparatus provided with the same.

### Background Art

In recent years, the wavelength of the light source for exposure has decreased along with refinement and high integration of a semiconductor integrated circuit. In particular, development of an extreme ultraviolet light source apparatus (hereinafter, also referred to as an "EUV light source apparatus") that radiates extreme ultraviolet light of a wavelength of 13.5 nm (hereinafter, also referred to as "EUV light") is progressing as a light source for next-generation semiconductor exposure.

Some methods for generating EUV light (EUV radiation) in the EUV light source apparatus are known. One of the methods is a method of generating a plasma by heating extreme ultraviolet light radiation species (hereinafter, also referred to as EUV radiation species) to excite them and taking out EUV light from the plasma.

As to a plasma-generating method, the EUV light source apparatus employing such a method is classified into a laser produced plasma (LPP) type and a discharge produced plasma (DPP) type.

The DPP type EUV light source apparatus applies a high voltage between electrodes supplied with discharge gas containing EUV radiation species (plasma raw material in gas phase), generates a high-density plasma by discharge, and utilizes extreme ultraviolet light radiated from it.

Patent Literature 1 has disclosed a DPP type light source apparatus. In this light source apparatus, an electrode surface that generates discharge is supplied with a liquid plasma raw material (e.g., tin (Sn) or lithium (Li)) containing EUV radiation species, the raw material is vaporized by radiating an energy beam such as a laser beam to the raw material, and a plasma is then generated by discharge. Such a method is also called laser assisted discharge produced plasma (LDP) method.

Moreover, an LPP type EUV light source apparatus irradiates a target material with laser light to excite the target material, thereby generating a plasma.

The EUV light source apparatus is used as a light source apparatus of a semiconductor exposure apparatus (lithographic apparatus) in semiconductor device manufacture as described above. Alternatively, the EUV light source apparatus is used as a light source apparatus of a test apparatus for a mask used for lithography. That is, the EUV light source apparatus is used as a light source apparatus of another optical system apparatus (utilization apparatus) that utilizes EUV light.

In the EUV light source apparatus, debris is scattered from the plasma. The debris contains plasma raw material particles (tin particles in a case where the plasma raw material is tin). Moreover, in a case where the plasma is generated by the DPP method or the LDP method, the debris contains material particles of a discharge electrode sputtered due to plasma generation.

When the debris reaches the utilization apparatus, the debris may damage or contaminate a reflection film of an optical element in the utilization apparatus, which can lower its performance. Therefore, a debris reduction apparatus (also referred to as debris mitigation tool (DMT)) that captures scattered debris in order to prevent the debris from entering the utilization apparatus has been proposed.

In general, the debris reduction apparatus uses a foil trap. A debris reduction apparatus employing the foil trap is used as the light source apparatus described in Patent Literature 1. This technology includes a foil trap with a rotation function (rotary foil trap) and a foil trap fixed without rotation (fixed foil trap).

The rotary foil trap includes a plurality of foils (thin films or thin flat plates) radially arranged in radial directions having a rotation shaft disposed in the center as a center and captures debris coming from a plasma by rotating the plurality of foils about such a rotation shaft as its center. Here, the rotation shaft is, for example, a shaft penetrating substantially the center of the plasma.

The fixed foil trap captures debris moving at a high speed that the rotary foil trap has failed to capture (in particular, ions, neutral atoms, and electrons, etc. of a plasma raw material moving at a high speed). The fixed foil trap has the central axis on the same axis as the rotation shaft of the rotary foil trap and includes a plurality of foils (thin films or thin flat plates) radially arranged in the radial directions from the central axis.

The plurality of foils of the fixed foil trap serve to increase the pressure by finely dividing a space where they are disposed to decrease the conductance of that portion. That is, the high-speed debris that the rotary foil trap has failed to capture decreases in speed because collision probability increases in the pressure-increased region in the fixed foil trap, such that the debris can be more easily captured by the foils of the fixed foil trap and a supporter of the foils.

It should be noted that EUV light radiated from the EUV light source apparatus is shaped as appropriate depending on the utilization apparatus. For example, in a case where the EUV light source apparatus is used as a light source apparatus of a mask test apparatus, an aperture member with an opening having a predetermined shape (corresponding to the heat shield plate to be described later) is disposed between a high-temperature plasma and the utilization apparatus.

Patent Literature 2 has disclosed a debris trap having an aperture member. In this debris trap, a fixed foil trap is disposed on a main light beam of taken-out EUV light to be taken out from the aperture member and has a shape corresponding to a region through which the taken-out EUV light passes.

### Citation List

### Patent Literature

Patent Literature 1: Japanese Patent No. 6075096
Patent Literature 2: Japanese Patent No. 6759732

### Disclosure of Invention

### Technical Problem

As described above, the fixed foil trap captures debris traveling at a high speed in a region where a pressure between the foils has increased. Probability of capturing this debris depends on the pressure between the foils.

In view of this, it is an objective of the present invention to provide a debris reduction apparatus that enables enhancement of debris-capturing probability and a light source apparatus provided with the same.

In view of the above-mentioned circumstances, it is an objective of the present technology to provide a debris reduction apparatus that enables enhancement of debris-capturing probability and a light source apparatus provided with the same.

### Solution to Problem

In order to accomplish the above-mentioned objective, a debris reduction apparatus according to an embodiment of the present technology includes a fixed foil trap.

The fixed foil trap includes an enclosure section, a plurality of foils, an inflow hole, and a pressure-increasing mechanism.

The enclosure section includes an incident port that light emitted from the light source enters, an emission port from which the light that has entered from the incident port is emitted, and an inner space through which the light travels.

The plurality of foils is fixed to a region of the inner space through which the light travels.

The inflow hole is configured in the enclosure section to communicate with the inner space and in which transparent gas transparent to the light flows.

The pressure-increasing mechanism includes at least one of an incident side member that is disposed in the incident port so that an opening area of the incident port decreases without blocking traveling of the light or an emission side member that is disposed in the emission port so that an opening area of the emission port decreases without blocking traveling of the light, the pressure-increasing mechanism increasing a pressure of the inner space.

In this debris reduction apparatus, the plurality of foils is disposed in the inner space of the enclosure section. Moreover, the transparent gas flows in the inner space. In addition, the pressure-increasing mechanism that increases the pressure of the inner space is disposed. Accordingly, the debris-capturing probability can be enhanced.

At least one of the incident side member or the emission side member may be a lid member that has a plate shape and includes an opening through which the light passes.

At least one of the incident side member or the emission side member may be a block member that has a block-like shape, includes an opening through which the light passes, and is disposed to fill the inner space.

The fixed foil trap may include an electromagnetic field generation unit that generates an electric field or a magnetic field that moves charged particles excited by the light of particles contained in the transparent gas in a direction away from the plurality of foils.

The inner space may include a buffer space where the plurality of foils does not exist. In this case, the inflow hole may be configured to communicate with the buffer space.

The fixed foil trap may be disposed between the light source and a utilization apparatus that utilizes the light emitted from the light source and between the light source and a monitor apparatus that monitors a state of the light emitted from the light source.

The light source may be a plasma.

The debris reduction apparatus may further include a rotary foil trap including a cover member including an incident port that the light emitted from the light source enters, an emission port from which the light that has entered from the incident port is emitted, and an inner space through which the light travels, and a plurality of rotation foils rotatably attached to a region of the inner space through which the light travels.

The rotary foil trap may include a pressure-increasing mechanism including at least one of an incident side member that is disposed in the incident port so that the opening area of the incident port decreases without blocking traveling of the light or an emission side member that is disposed in the emission port so that the opening area of the emission port decreases without blocking traveling of the light, the pressure-increasing mechanism increasing a pressure of the inner space.

The fixed foil trap and the rotary foil trap may be disposed at positions where the emission port of the rotary foil trap and the incident port of the fixed foil trap face each other. In this case, the debris reduction apparatus may further include a coupling member that couples the emission port of the rotary foil trap and the incident port of the fixed foil trap to each other.

The debris reduction apparatus may include an aperture member that is disposed between the light source and the rotary foil trap and includes an opening that takes out part of the light emitted from the light source.

A light source apparatus according to an embodiment of the present technology includes: a plasma generation chamber that excites a raw material that radiates light and generates plasma; a light-taking out section that takes out light emitted from the plasma; and a debris reduction apparatus that includes a fixed foil trap.

The debris reduction apparatus further includes the above-mentioned rotary foil trap.

### Advantageous Effects of Invention

In accordance with the present invention, the debris-capturing probability can be enhanced. It should be noted that the effects described here are not necessarily limitative and any effect described in the present disclosure may be provided.

### Brief Description of Drawings

- [Fig. 1]: A schematic view showing a configuration example of a light source apparatus according to an embodiment of the present technology.
- [Fig. 2]: A schematic view showing a configuration example of the light source apparatus according to the embodiment of the present technology.
- [Fig. 3]: A schematic view showing a configuration example of a rotary foil trap.
- [Fig. 4]: A schematic view showing a configuration example of a fixed foil trap in a reference example.
- [Fig. 5]: A schematic view showing a configuration example of the fixed foil trap in the reference example.
- [Fig. 6]: A schematic view showing a configuration example of the fixed foil trap.
- [Fig. 7]: A schematic view showing a configuration example of the fixed foil trap.
- [Fig. 8]: A schematic view showing a configuration example of the fixed foil trap.
- [Fig. 9]: A schematic view showing a configuration example of a pressure adjustment plate.
- [Fig. 10]: A schematic view showing a configuration example of the pressure adjustment plate.
- [Fig. 11]: A schematic view showing a flow of argon gas in a debris reduction apparatus according to a comparative example.
- [Fig. 12]: A schematic view showing a flow of argon gas in a debris reduction apparatus according to the present technology.
- [Fig. 13]: A schematic view showing a configuration example of a cavity-limiting member.
- [Fig. 14]: A schematic view showing a configuration example of the cavity-limiting member.
- [Fig. 15]: A schematic view showing a configuration example of the cavity-limiting member.
- [Fig. 16]: A schematic view showing a configuration example of a space connection member.
- [Fig. 17]: A schematic view showing a configuration example of a front closing section.
- [Fig. 18]: A schematic view showing a configuration example in which the fixed foil trap is disposed between the rotary foil trap and a monitor apparatus.
- [Fig. 19]: A schematic view showing a configuration example of a magnetic field application means.
- [Fig. 20]: A schematic view showing a configuration example of the magnetic field application means.
- [Fig. 21]: A schematic view showing a configuration example of the magnetic field application means.
- [Fig. 22]: A schematic view showing a configuration example of a buffer space.

### Mode(s) for Carrying Out the Invention

Hereinafter, embodiments according to the present technology will be described with reference to the drawings.

### [Light Source Apparatus]

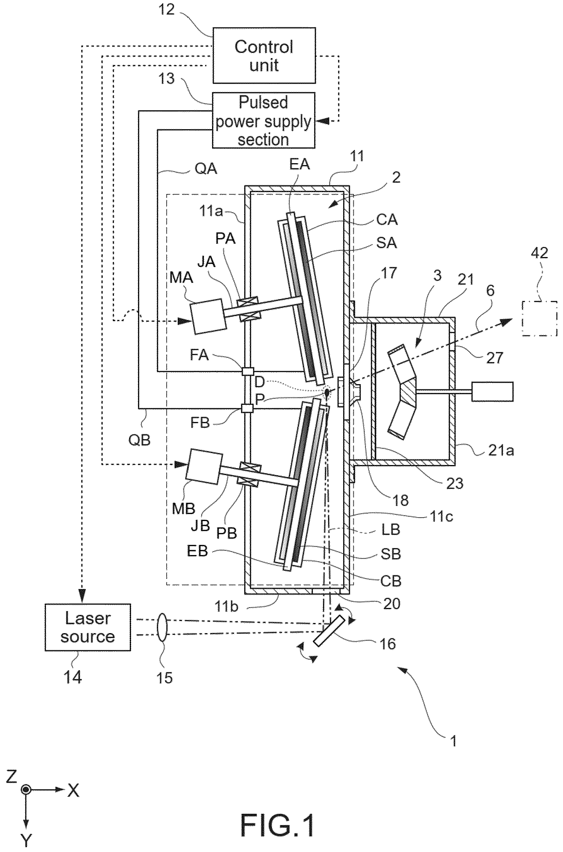

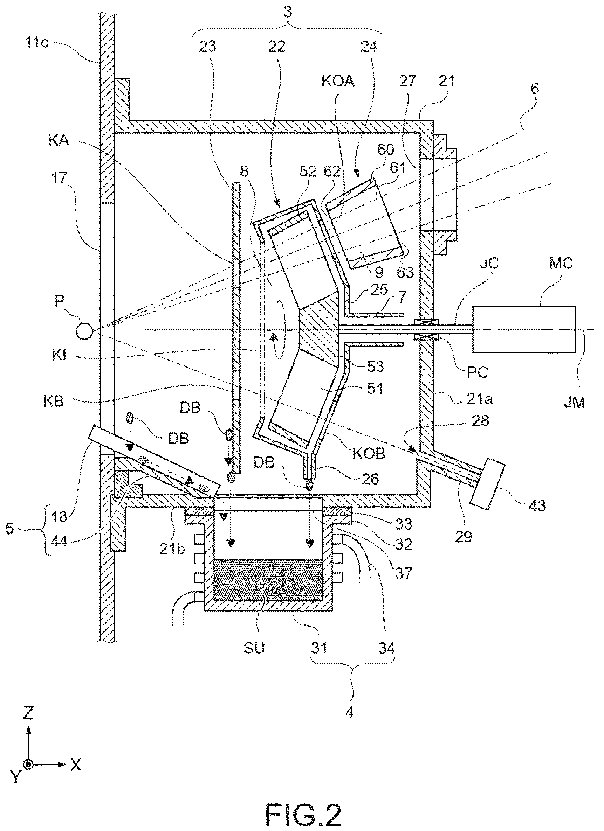

Figs. 1 and 2 are schematic views each showing a configuration example of a light source apparatus.

Fig. 1 is a view of a schematic cross-section of a light source apparatus 1 taken along a horizontal direction at a predetermined height position from an installation surface as viewed from a positive direction side in a Z direction. Hereinafter, the description will be made assuming that the X direction is left and right directions (the positive side of the X-axis is a right side and the negative side is a left side), the Y direction is a depth direction (the positive side of the Y-axis is a front side and the negative side is a deep side), and the Z direction is upper and lower directions (the positive side of the Z-axis is an upper side and the negative side is a lower side). As a matter of course, regarding the application of the present technology, orientations in which the light source apparatus 1 is used and the like are not limited.

Fig. 2 is a schematic view showing a part of the light source apparatus 1, which corresponds to a debris reduction apparatus 3. In Fig. 2, a state of a cross-section of the light source apparatus 1 taken along the XZ plane as viewed from the front side is shown.

The light source apparatus 1 is an LDP type EUV light source apparatus and radiates extreme ultraviolet light (EUV light). The light source apparatus 1 can be used as a light source apparatus of a lithographic apparatus in for example semiconductor device manufacture or as a light source apparatus of a test apparatus for a mask used for lithography. For example, in a case where the light source apparatus 1 is used as a light source apparatus for a mask test apparatus, part of the EUV light radiated from a plasma is taken out and is guided to the mask test apparatus. Then, the mask test apparatus performs a blank test or a pattern test for the mask by using EUV light radiated from the light source apparatus 1 as test light.

The light source apparatus 1 includes a light source section 2, the debris reduction apparatus 3, a debris storage section 4, a debris guide section 5, a control unit 12, a pulsed power supply section 13, a laser source 14, a condenser lens 15, a movable mirror 16, and a connection chamber 21.

### [Light Source Section]

The light source section 2 includes a chamber 11, containers CA and CB, discharge electrodes EA and EB, and motors MA and MB. In Fig. 1, the light source section 2 is shown as a dashed rectangle.

The chamber 11 is an enclosure that accommodates various mechanisms of the light source section 2. In the present embodiment, the chamber 11 has a rectangular parallelepiped shape. The chamber 11 is made of for example a rigid material such as metal. As a matter of course, specific shape, material, and the like of the chamber 11 are not limited.

The inside of the chamber 11 is maintained at a pressure-reduced atmosphere equal to or lower than a predetermined pressure through a vacuum pump (not shown). Feedthroughs FA and FB are disposed in a left side wall 11a of the chamber 11. The feedthroughs FA and FB are seal members that enables power lines and the like to be inserted into the chamber 11 while maintaining the pressure-reduced atmosphere inside the chamber 11.

A transparent window 20 is disposed in a front side wall 11b of the chamber 11. A first window section 17 that is a through-hole is configured in a right side wall 11c of the chamber 11. In the present embodiment, the transparent window 20 is made of a material transparent to a laser beam. Specific configurations such as a shape of the first window section 17 and material and shape of the transparent window 20 are not limited.

The containers CA and CB are containers that store a plasma raw material. In the present embodiment, the containers CA and CB are each made of a conductive material. A plasma raw material SA is stored in the container CA. Moreover, a plasma raw material SB is stored in the container CB. The plasma raw materials SA and SB are raw materials in liquid phase that have been heated. In the present embodiment, tin (Sn) is used as the plasma raw materials SA and SB. Alternatively, another raw material that enables generation of a plasma, such as lithium (Li), may be used.

The discharge electrodes EA and EB each have a disk shape. The discharge electrodes EA and EB are each made of a high-melting-point metal such as molybdenum (Mo), tungsten (W), or tantalum (Ta). Specific materials of the discharge electrodes EA and EB are not limited.

For example, a discharge electrode EA is used as a cathode and a discharge electrode EB is used as an anode. The discharge electrodes EA and EB are disposed, spaced apart from each other. Moreover, the discharge electrodes EA and EB are disposed so that parts of circumferential portions of the discharge electrodes EA and EB are located in proximity to each other. A gap at a position where the circumferential portions of the discharge electrodes EA and EB are the closest to each other is a discharge region D by the discharge electrodes EA and EB.

Moreover, the discharge electrode EA is disposed so that a lower portion (deep side in Fig. 1) of the discharge electrode EA is immersed in the plasma raw material SA stored in the container CA. Similarly, the discharge electrode EB is also disposed so that its lower portion is immersed in the plasma raw material SB.

A motor MA rotates the discharge electrode EA. The motor MA has a rotation shaft JA. A base of the motor MA is disposed on the external left side of the chamber 11 and the rotation shaft JA connected to the base externally extends into the chamber 11. An end portion of the rotation shaft JA inside the chamber 11 is connected to the center of the discharge electrode EA (center of the circular surface).

A gap between the rotation shaft JA and the wall of the chamber 11 is sealed with a seal member PA. For example, a mechanical seal is used as the seal member PA. With the seal member PA, the rotation shaft JA is rotatably supported while the pressure-reduced atmosphere in the chamber 11 is maintained.

Similarly, the motor MB includes a rotation shaft JB and the rotation shaft JB is connected to the center of the discharge electrode EB. Moreover, a gap between the rotation shaft JB and the wall of the chamber 11 is sealed with a seal member PB.

It should be noted that the discharge electrodes EA and EB are disposed so that their axis lines (extending directions of their rotation shafts) are not parallel. Specifically, as shown in Fig. 1, the discharge electrode EA is disposed in a state in which the front side (lower side in Fig. 1) is tilted rightwards and the deep side (upper side in Fig. 1) is tilted leftwards. On the other hand, the discharge electrode EB is disposed in a state in which the front side is tilted leftwards and the deep side is tilted rightwards. As for a space between the rotation shafts JA and JB in the depth direction (upper and lower directions, Z direction in Fig. 1), it is smaller on the side of the motors MA and MB and is larger on the side of the discharge electrodes EA and EB. In addition, the discharge electrode EB, the motor MB, and the rotation shaft JB are disposed sightly on the left side with respect to the discharge electrode EA, the motor MA, and the rotation shaft JA.

The light source section 2 corresponds to an embodiment of a plasma generation chamber according to the present technology.

The control unit 12 controls operations of the respective sections of the light source apparatus 1. For example, the control unit 12 controls rotational driving of the motors MA and MB so that the discharge electrodes EA and EB are rotated at predetermined r.p.m. Moreover, the control unit 12 controls the operation of the pulsed power supply section 13, the irradiation timing of the laser beam by the laser source 14, and the like.

The control unit 12 is realized by a controller with hardware necessary for computer configurations, for example, processors such as CPU, GPU, and DSP, memories such as ROM and RAM, storage devices such as an HDD, and the like. Specifically, the control unit 12 is realized as a functional block by the CPU of the controller executing a program (e.g., application program) according to the present technology.

The pulsed power supply section 13 causes electric discharge in the discharge region D by supplying the discharge electrodes EA and EB with pulsed power. Power supply lines QA and QB are connected to the pulsed power supply section 13. The power supply line QA is inserted into the chamber 11 via the feedthrough FA and is connected to the container CA. The power supply lines QB is inserted into the chamber 11 via the feedthrough FB and is connected to the container CB.

The laser source 14 emits an energy beam that vaporizes the plasma raw materials SA and SB. The laser source 14 is disposed outside the chamber 11. For example, an Nd: neodymium-doped yttrium orthovanadate (YVO₄) laser apparatus is used as the laser source 14. In this case, a laser beam LB of an infrared region of a wavelength of 1064 nm is emitted by the laser source 14. As a matter of course, specific configurations of the laser source 14 such as the type of apparatus for the laser source 14 and the wavelength of the laser beam LB to be radiated are not limited as long as it can vaporize the plasma raw materials SA and SB.

The condenser lens 15 is disposed on the optical path of the laser beam LB outside the chamber 11. When the laser beam LB emitted by the laser source 14 enters the condenser lens 15, the spot diameter of the laser beam LB is adjusted.

The movable mirror 16 is disposed on the optical path of the laser beam LB outside the chamber 11. The movable mirror 16 is disposed behind the condenser lens 15 on the optical path of the laser beam LB. That is, the laser beam LB that has passed the condenser lens 15 enters the movable mirror 16.

The laser beam LB that has entered the movable mirror 16 is reflected by the movable mirror 16 and passes through the transparent window 20 of the chamber 11. Then, the laser beam LB reaches the circumferential portion of the discharge electrode EA in vicinity of the discharge region D inside the chamber 11. It should be noted that the irradiation position of the laser beam LB to the discharge electrode EA can be adjusted by changing the attitude of the movable mirror 16.

The connection chamber 21 is an enclosure that accommodates a mechanism such as the debris reduction apparatus 3. The connection chamber 21 has a rectangular parallelepiped shape and entire one surface of the six surfaces is a rectangular opening. The connection chamber 21 is connected to the chamber 11 so that a frame constituting the opening is held in contact with the right side wall 11c of the chamber 11.

The connection chamber 21 is made of a rigid material such as metal. As a matter of course, specific shape, material, and the like of the connection chamber 21 are not limited. The inside of the connection chamber 21 is maintained at a pressure-reduced atmosphere equal to or lower than a predetermined pressure.

In an upper portion of a right side wall 21a of the connection chamber 21, a second window section 27 is configured. The second window section 27 is a through-hole having a predetermined shape. An EUV light-guiding hole 28 is configured in a lower portion of the right side wall 21a. Moreover, a guide pipe 29 is configured to extend to the lower right side from the EUV light-guiding hole 28. In addition, an opening 37 for connecting the debris storage section 4 is configured in a lower side wall 21b.

### [Operation of Light Source Section]

The light source section 2 excites a raw material (plasma raw materials SA and SB) that radiates light to generate a plasma P. Moreover, the light source section 2 generates EUV light 6, using the plasma P as a light emission point. Hereinafter, specific contents regarding generation of the plasma P and the EUV light 6 by the light source section 2 will be described.

First of all, the control unit 12 controls the operation of the pulsed power supply section 13 so that the pulsed power supply section 13 supplies the container CA with pulsed power. The pulsed power is supplied via the power supply line QA.

The container CA is made of a conductive material. Moreover, the plasma raw material SA has been stored in the container CA and a lower portion of the discharge electrode EA has been immersed in the plasma raw material SA. Thus, the pulsed power supply section 13, the container CA, the plasma raw material SA, and the discharge electrode EA have been each electrically connected. That is, the pulsed power supply section 13 supplies pulsed power to the discharge electrode EA. Similarly, the pulsed power supply section 13 supplies the pulsed power to the discharge electrode EB.

Moreover, the control unit 12 controls rotational driving of the motor MA to rotate the discharge electrode EA. The rotation of the discharge electrode EA transports the plasma raw material SA to the vicinity of the discharge region D with the plasma raw material SA adhering to the surface of the discharge electrode EA. Similarly, the plasma raw material SB is transported to the vicinity of the discharge region D with the plasma raw material SB adhering to the surface of the discharge electrode EB.

Moreover, the control unit 12 controls the operation of the laser source 14 so that the laser source 14 emits the laser beam LB. The laser beam LB is emitted rightwards and reaches the movable mirror 16 via the condenser lens 15. In addition, the laser beam LB is reflected by the movable mirror 16 on the deep side (upper side in Fig. 1), travels inside the chamber 11 via the transparent window 20, and reaches the circumferential portion of the discharge electrode EA in vicinity of the discharge region D.

It should be noted that the discharge electrode EB is disposed in a state in which the front side (lower side in Fig. 1) is the left side. Moreover, the discharge electrode EB is disposed, slightly shifted to the left with respect to the discharge electrode EA. Thus, the optical path of the laser beam LB is not shielded by the discharge electrode EB. By arranging the discharge electrode EB in this manner, it is possible to easily irradiate the discharge electrode EA with the laser beam LB.

The plasma raw material SA transported in vicinity of the discharge region D by the discharge electrode EA is vaporized by irradiation with the laser beam LB and becomes the plasma raw material SA in gas phase in the discharge region D. Similarly, the plasma raw material SB also becomes the plasma raw material SB in gas phase in the discharge region D.

Moreover, by supplying the discharge electrodes EA and EB with the pulsed power, electric discharge occurs between the discharge electrodes EA and EB (in the discharge region D). With the electric discharge, the plasma raw materials SA and SB in gas phase located in the discharge region D is heated and excited by a current to generate the plasma P.

In addition, the EUV light 6 is radiated from the plasma P. Part (rightward light) of the radiated EUV light 6 passes through the first window section 17 and is emitted to the inside of the connection chamber 21. In Fig. 1, an example of the optical path of the EUV light 6 that has passed through the first window section 17 is shown as the dashed arrow. The plasma P corresponds to an embodiment of the light source according to the present technology.

It should be noted that in the present embodiment, the inside of the chamber 11 and the connection chamber 21 is maintained at a pressure-reduced atmosphere equal to or lower than a predetermined pressure. Accordingly, it is possible to favorably cause electric discharge for heating and exciting the plasma raw materials SA and SB. Moreover, it is possible to suppress attenuation of the EUV light 6.

Debris DB as well as the EUV light 6 are scattered from the plasma P in various directions at a high speed. The debris DB includes tin particles that are the plasma raw materials SA, SB. Moreover, the debris DB includes the material particles of the discharge electrodes EA and EB sputtered due to generation of the plasma P. Specifically, the debris DB includes ions, neutral atoms, and electrons moving at a high speed. The debris DB can get a large kinetic energy through the process of contraction and expansion of the plasma P. Part of the debris DB passes through the first window section 17 and is scattered into the connection chamber 21.

### [Debris Reduction Apparatus]

The debris reduction apparatus 3 captures the debris DB scattered from the plasma P. The debris reduction apparatus 3 includes a rotary foil trap 22, a heat shield plate 23, and a fixed foil trap 24. These mechanisms are all disposed inside the connection chamber 21.

The heat shield plate 23 is a plate-shaped member and is disposed in parallel with a YZ plane. Moreover, the heat shield plate 23 is disposed between the plasma P and the rotary foil trap 22. An opening KA is configured in an upper portion of the heat shield plate 23. Moreover, an opening KB is configured in a lower portion of the heat shield plate 23. The EUV light 6 emitted by the plasma P enters a left surface of the heat shield plate 23 and passes through the openings KA and KB. Thus, the shape of the EUV light 6 emitted to a right side of the heat shield plate 23 is a shape corresponding to the shapes of the opening KA and the opening KB.

In this manner, part of the EUV light 6 emitted from the plasma P is taken out through the openings KA and KB. For example, depending on the shape of the EUV light 6 wished to be taken out, the shapes of the openings KA and KB are each set to be a shape such as a circular shape as appropriate. As a matter of course, specific shapes of the openings KA and KB are not limited.

Moreover, the heat shield plate 23 is made of a high-melting-point metal such as tungsten (W) or molybdenum (Mo). Configurations such as specific material and shape of the heat shield plate 23 are not limited. The heat shield plate 23 corresponds to an embodiment of an aperture member according to the present technology.

The rotary foil trap 22 captures the debris DB scattered from the plasma P. The rotary foil trap 22 includes a cover member 25, a plurality of rotation foils 51, an outer ring 52, a central support column 53, and a motor MC.

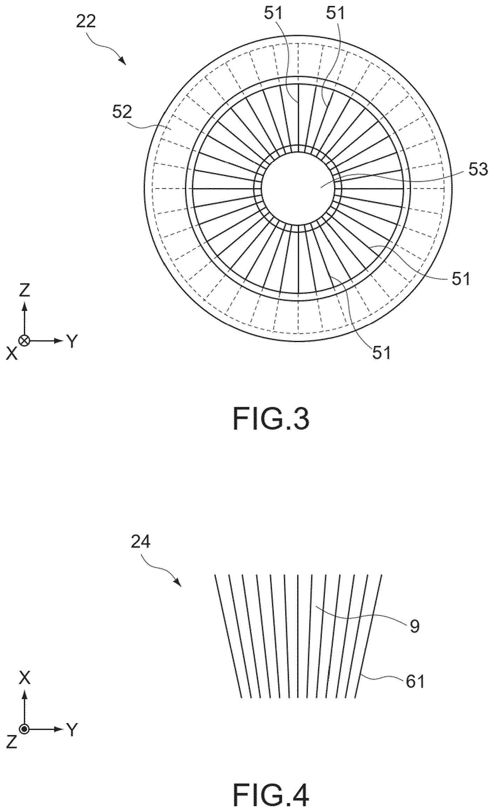

Fig. 3 is a schematic view showing a configuration example of the rotary foil trap 22.

In Fig. 3, states of the plurality of rotation foils 51, the outer ring 52, and the central support column 53 out of the rotary foil trap 22 as viewed from the left side (incident side of the EUV light 6) in Figs. 1 and 2 are shown.

The outer ring 52 is a ring-shaped member. The outer ring 52 is disposed to be concentric with the central support column 53. The rotation foils 51 are thin films or thin flat plates. Each rotation foil 51 is disposed between the outer ring 52 and the central support column 53. The rotation foils 51 are radially arranged at substantially equal angular intervals with respect to the central support column 53. Thus, each rotation foil 51 is positioned on a plane including a central axis line JM of the central support column 53. The rotation foils 51, the outer ring 52, and the central support column 53 are configured so that the positions of the respective members protrude to the right side of Figs. 1 and 2 (deep side in Fig. 3) as it approaches the center from the outer periphery.

The rotation foils 51, the outer ring 52, and the central support column 53 are each made of a high-melting-point metal such as tungsten or molybdenum. Specific configurations such as materials of the rotation foils 51, the outer ring 52, and the central support column 53 are not limited.

The motor MC rotates the rotation foils 51, the outer ring 52, and the central support column 53. The motor MC includes a rotation shaft JC. A base of the motor MC is disposed on an external right side of the connection chamber 21 and the rotation shaft JC connected to the base externally extends into the connection chamber 21. An end portion of the rotation shaft JC, which is located inside the connection chamber 21, is connected to the center of a right surface of the central support column 53.

The gap between the rotation shaft JC and the wall of the connection chamber 21 is sealed with a seal member PC. With the seal member PC, the rotation shaft JC is rotatably supported while the pressure-reduced atmosphere in the connection chamber 21 is maintained.

The central axis line JM of the central support column 53 matches the central axis line of the rotation shaft JC. That is, the rotation shaft JC can be considered as a rotation shaft of the rotation foils 51, the outer ring 52, and the central support column 53. The rotation foils 51, the outer ring 52, and the central support column 53 integrally rotate due to driving of the motor MC.

The cover member 25 is a member surrounding the rotation foils 51, the outer ring 52, and the central support column 53. In the present embodiment, the cover member 25 has a shape substantially similar to the rotation foils 51, the outer ring 52, and the central support column 53.

The cover member 25 includes an inner space 8 and the rotation foils 51, the outer ring 52, and the central support column 53 are disposed in the inner space 8. A through-hole 7 protruding rightwards is configured at the center of the right surface of the cover member 25 and the rotation shaft JC of the motor MC is inserted therein. Moreover, an exhaust pipe 26 protruding downwards is configured in a lower portion of the cover member 25.

Moreover, an opening KI is configured in a left surface of the cover member 25. The opening KI is configured in substantially the entire area of the left surface. An opening KOA is configured in an upper portion of the right surface of the cover member 25. An opening KOB is configured in the right surface of the lower portion of the cover member 25.

The openings KI, KOA, and KOB have such shapes that any of them does not block the traveling of the EUV light 6. In Fig. 2, a region where the EUV light 6 travels is shown as the dashed line. The shapes of the openings KI, KOA, and KOB are shapes including the region where the EUV light 6 travels. That is, the EUV light 6 passes through the opening KI, travels the inner space 8 of the cover member 25, passes through the openings KOA and KOB, and travels outside the rotary foil trap 22, but the cover member 25 does not block the traveling of the EUV light 6 during this process.

Specific shapes of the openings KI, KOA, and KOB are not limited. The opening KI corresponds to an embodiment of an incident port of a cover member according to the present technology. The openings KOA and KOB correspond to an embodiment of an emission port of the cover member according to the present technology.

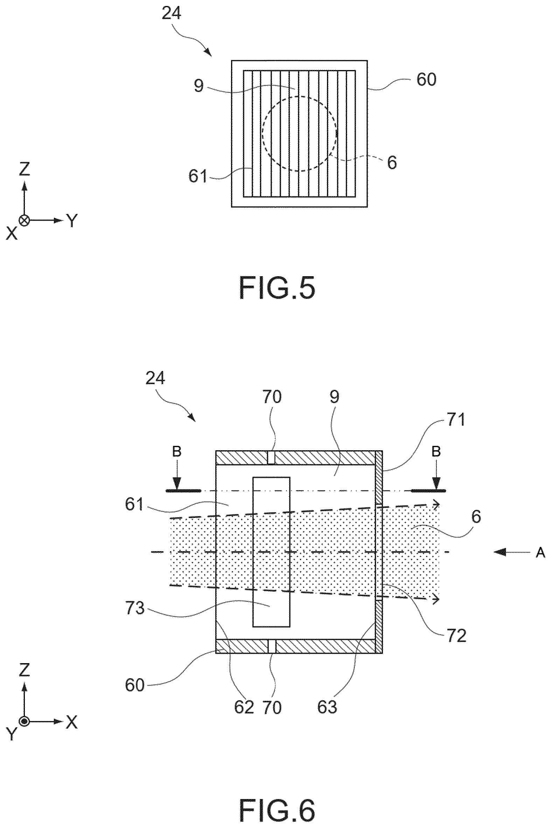

Figs. 4 and 5 are schematic views each showing a configuration example of the fixed foil trap 24 in a reference example.

It should be noted that the fixed foil trap 24 in the present technology will be described later in a first embodiment.

In Fig. 4, a state of the fixed foil trap 24 as viewed from the positive side in the Z direction (upper side in Fig. 2) is shown. It should be noted that the illustration of an enclosure section 60 is omitted in Fig. 4. In Fig. 5, a state of a cross-section pf the fixed foil trap 24 taken along the YZ plane as viewed from a negative side in the X direction (left side in Fig. 2) is shown. It should be noted that although the fixed foil trap 24 is disposed in a slightly tilted state in Fig. 2, the description will be made for the sake of easy understanding of the description, assuming that in Figs. 4 and 5, the fixed foil trap 24 is not tilted with respect to the X direction, the Y direction, and the Z direction.

The fixed foil trap 24 includes an enclosure section 60 and a plurality of foils 61. The enclosure section 60 has a rectangular parallelepiped shape. A rectangular incident port 62 is configured in a left surface of the enclosure section 60. A rectangular emission port 63 is configured in a right surface of the enclosure section 60. Moreover, the enclosure section 60 has an inner space 9 as a space surrounded by four surfaces on the front side, deep side, upper side, and lower side (right side, left side, upper side, and lower side in Fig. 6).

The fixed foil trap 24 is disposed at a position where the opening KOA of the rotary foil trap 22 and the incident port 62 of the fixed foil trap 24 face each other. Specific configurations such as shape and material of the enclosure section 60 are not limited.

The plurality of foils 61 is thin films or thin flat plates. The foils 61 are disposed in the inner space 9 of the enclosure section 60. The foils 61 are arranged at equal intervals in the Y direction. Moreover, as shown in Fig. 4, the foils 61 are radially arranged so that the spaces between the foils 61 increase as it approaches the positive side in the Z direction. That is, the foils 61 in the center are disposed in parallel with the XZ plane and other foils 61 are disposed, slightly tilted in the Y direction. An upper side portion and a lower side portion of the foil 61 (front side portion and deep side portion in Fig. 4) are fixed to an inner surface of the enclosure section 60.

The foil 61 is made of a high-melting-point metal such as tungsten or molybdenum. Specific configurations such as a material of the foils 61, the number of foils, and arrangement are not limited.

The debris storage section 4 is a container that stores the debris DB. The debris storage section 4 includes a debris storage container 31 and a heater wire 34. The debris storage container 31 has a rectangular parallelepiped shape. A rectangular opening surrounded by a flange 32 is configured in an upper surface of the debris storage container 31. The debris storage container 31 is connected to the connection chamber 21 so that the flange 32 overlaps the opening 37 of the connection chamber 21. Specifically, for example, the flange 32 is fixed to the connection chamber 21 by screwing. Moreover, a gap between the flange 32 and the connection chamber 21 is sealed with a gasket 33. As a matter of course, specific configurations such as material and shape of the debris storage container 31, and a connection method to the connection chamber 21 are not limited.

The heater wire 34 heats the debris storage container 31. In the present embodiment, the heater wire 34 is wound around the debris storage container 31. The present technology is not limited thereto, and another heating means may be embedded in the debris storage container 31.

The debris guide section 5 guides the debris DB to the debris storage section 4. The debris guide section 5 includes a receiving plate member 18 and a support base 44. The support base 44 is configured at lower left corner portions inside the connection chamber 21, tilted to the lower right.

The receiving plate member 18 is a member that is a receiving plate for the debris DB. The receiving plate member 18 is disposed on the support base 44. Moreover, the receiving plate member 18 has a rectangular shape. The receiving plate member 18 is disposed to slightly project inside the chamber 11 with the left side portion penetrating the first window section 17. Moreover, the receiving plate member 18 is disposed so that the right side portion is positioned in vicinity of the opening 37. Specific configurations such as shape and material of the receiving plate member 18 are not limited.

### [Traveling of EUV Light]

Traveling of the EUV light 6 emitted from the light source section 2 will be described. The EUV light 6 radiated from the plasma P in the light source section 2 passes through the first window section 17 and travels inside the connection chamber 21. The EUV light 6 first reaches the heat shield plate 23. Traveling of part of the EUV light 6 is blocked by the heat shield plate 23 and the other part passes through the openings KA and KB. Thus, the EUV light 6 having a shape corresponding to the shapes of the openings KA and KB is emitted to the right side of the heat shield plate 23.

Next, the EUV light 6 enters the rotary foil trap 22 from the opening KI of the cover member 25. In the inner space 8 of the cover member 25, the plurality of rotation foils 51 is rotatably attached to a region of the inner space 8 where the EUV light 6 travels. That is, the plurality of rotation foils 51 rotates in the region where the EUV light 6 travels. For example, the control unit 12 controls driving of the motor MC s that the rotation foils 51 rotate.

Rotation foils 51 are disposed in parallel with a traveling direction of the EUV light 6. Thus, an amount of EUV light 6, which corresponds to the thickness of the rotation foils 51, is shielded and a large part of the EUV light 6 is emitted to the outside of the rotary foil trap 22. With such an arrangement configuration of the rotation foils 51, it is possible to maximize the percentage of the EUV light 6 that passes through the rotary foil trap 22 (also referred to as transmittance).

The EUV light 6 emitted from the opening KOA to the outside of the rotary foil trap 22 enters the incident port 62 of the fixed foil trap 24. Then, the EUV light 6 travels the inner space 9 of the enclosure section 60. In the inner space 9, the plurality of foils 61 is fixed to the region of the inner space 9 through which the EUV light 6 travels.

The foils 61 are disposed in parallel with the traveling direction of the EUV light 6. Thus, an amount of the EUV light 6, which corresponds to the thickness of the foils 61, is shielded and a large part of the EUV light 6 is emitted to the outside of the fixed foil trap 24.

The EUV light 6 emitted from the emission port 63 of the fixed foil trap 24 passes through the second window section 27 and is emitted toward a utilization apparatus 42. The utilization apparatus 42 is an apparatus that utilizes the EUV light 6. That is, in view of the general operation of the light source apparatus 1, it can be said that the second window section 27 takes out light emitted from the plasma P and the utilization apparatus 42 utilizes the light. The second window section 27 corresponds to an embodiment of a light-taking out section according to the present technology.

On the other hand, the EUV light 6 that has passed through the opening KB passes through a lower portion of the rotary foil trap 22 and is emitted from the opening KOB. In addition, the EUV light 6 enters the EUV light-guiding hole 28 and passes through the inside of the guide pipe 29.

A monitor apparatus 43 is provided at an outlet of the guide pipe 29. The monitor apparatus 43 is a detector that detects the EUV light 6 or a measurement unit that measures the intensity of the EUV light 6. For example, on the basis of a monitoring result by the monitor apparatus 43, emission intensity, emission timing, and the like of the EUV light 6 may be controlled.

### [Capturing of Debris]

Specific contents regarding capturing of the debris DB by the debris reduction apparatus 3 will be described. The debris DB is scattered from the plasma P together with the EUV light 6. The debris DB is scattered in various directions and part thereof passes through the first window section 17 and enters the connection chamber 21.

Part of the debris DB that has entered the connection chamber 21 is deposited on the left surface of the heat shield plate 23. When the debris DB deposited on the heat shield plate 23 is molten by radiation from the plasma P and reaches a certain amount, the debris DB moves to a lower portion of the heat shield plate 23 as droplets due to the gravity. Then, the debris DB moves away from the heat shield plate 23 and is stored in the debris storage container 31 disposed below the heat shield plate 23. In Fig. 2, a state in which the debris DB as the droplets on the heat shield plate 23 flows in the debris storage container 31 is schematically shown.

The arrangement of the heat shield plate 23 reduces the amount of debris DB that travels to the rotary foil trap 22. Accordingly, the load of the rotary foil trap 22 decreases. Moreover, the heat shield plate 23 suppresses thermal conduction from the plasma P to the rotary foil trap 22 and the like, which prevents overheating of the rotary foil trap 22 and the like. It should be noted that since the heat shield plate 23 is made of the high-melting point material, the heat shield plate 23 is not significantly deformed due to heat of the plasma P.

On the other hand, part of the debris DB passes through the openings KA and KB and travels to the right side of the heat shield plate 23. The debris DB enters the rotary foil trap 22. Since the rotation foils 51 are rotating in the rotary foil trap 22, the rotation foils 51 actively collide with the debris DB. Accordingly, the rotation foils 51 capture the debris DB.

The debris DB captured by the rotation foils 51 moves on the rotation foils 51 along the radial directions due to centrifugal force, moves away from end portions of the rotation foils 51, and adheres to an inner surface of the cover member 25. The cover member 25 surrounding the rotation foils 51 in this manner prevents scattering of the debris DB into the connection chamber 21.

A heating means whose illustration is omitted heats the cover member 25. Alternatively, secondary radiation from the heat shield plate 23 subjected to EUV radiation heats the cover member 25. Due to the heated cover member 25, the debris DB adhering to the inner surface of the cover member 25 is maintained in liquid phase without solidification. The debris DB adhering to the inner surface of the cover member 25 gathers in the lower portion of the cover member 25 due to the gravity, is discharged outside the cover member 25 from the lower portion of the cover member 25 through the exhaust pipe 26, and is stored in the debris storage container 31. In Fig. 2, a state in which the debris DB discharged from the exhaust pipe 26 flows in the debris storage container 31 is schematically shown.

The rotary foil trap 22 captures the debris DB traveling at a relatively low speed. Thus, the debris DB traveling at a high speed passes through the opening KOA and travels to a right side of the rotary foil trap 22 without the rotary foil trap 22 capturing the debris DB in some cases. The debris DB enters the fixed foil trap 24 through the incident port 62. Then, the debris DB collides with the foils 61. The fixed foil trap 24 captures the debris DB traveling at a high speed, which the rotary foil trap 22 has failed to capture in this manner.

### [Collection of Waste Material]

A small amount of plasma raw material SA out of the plasma raw material SA (tin), which adheres to the discharge electrode EA and is transported to the discharge region D, is vaporized due to irradiation with an energy beam and utilized for generation of the plasma P. Therefore, although a large part of the plasma raw material SA adhering to the discharge electrode EA is returned to the container CA without being used, part thereof falls due to the gravity without returning to the container CA and a part of the plasma raw material SA in liquid phase stored in the container CA may flow out of the container CA due to a certain defect. Similarly, a part of the plasma raw material SB may flow out of the container CB.

The receiving plate member 18 receives a waste material falling in the gravity direction in this manner. The receiving plate member 18 is heated by the heating means (not shown) and maintained at a temperature equal to or higher than the melting point (about 232 °C) of tin that is the waste material. Thus, the waste material moves along the receiving surface of the tilted receiving plate member 18 and flows in the debris storage container 31, maintained in liquid phase.

In Fig. 2, a state in which a stored material SU including the waste material and the debris DB remains in the debris storage container 31 is schematically shown. Since the waste material is tin and a large part of the debris DB is also tin, it can also be said that the debris storage container 31 is a tin collection container.

When the light source apparatus 1 is running, the heater wire 34 is powered on and the inside of the debris storage container 31 is heated at a temperature equal to or higher than the melting point of tin. Thus, tin remaining inside the debris storage container 31 becomes liquid.

When tin is solidified inside the debris storage container 31, the accumulation of the debris storage container 31 at a point where the debris DB falls grows like stalagmites of a limestone cave. When the accumulation of the debris DB grows like stalagmites, for example, the exhaust pipe 26 of the cover member 25 is blocked by the debris DB and the debris DB is accumulated inside the cover member 25. In addition, the debris DB accumulated in the cover member 25 comes into contact with the rotary foil trap 22 and blocks rotation of the rotary foil trap 22 or damages the rotary foil trap 22 in some cases.

Alternatively, the openings KOA and KOB provided in the cover member 25 are partially blocked by the debris DB accumulated in the cover member 25, which blocks the traveling of the EUV light 6 in the openings KOA and KOB in some cases.

In order to prevent such a situation, tin is maintained in liquid phase by heating. Accordingly, it is possible to flatten tin in the debris storage container 31 and store the tin while avoiding the growth like stalagmites.

It should be noted that in a case of collecting tin remaining in the debris storage container 31, the power supply to the heater wire 34 is stopped and the heating of the inside of the debris storage container 31 is halted. The temperature of the debris storage container 31 returns to the room temperature and the stored tin is solidified, and then the air pressure inside the connection chamber 21 is returned to the atmospheric pressure. Then, the debris storage container 31 is removed from the connection chamber 21 and a new debris storage container 31 containing no tin is attached to the connection chamber 21.

Although the tin inside the removed debris storage container 31 is solid, it is possible to remove the tin from the debris storage container 31 by re-heating the debris storage container 31 so that the inside tin is made liquid again. In this manner, the removed debris storage container 31 can be reused.

### <First Embodiment>

Referring to Figs. 6 to 12, a more detailed embodiment of the light source apparatus 1 according to the present technology will be described. Hereinafter, descriptions of portions similar to the configurations and actions in the light source apparatus 1 described above will be omitted or simplified.

### [Fixed Foil Trap]

Hereinafter, a more detailed configuration of the fixed foil trap 24 according to the present technology will be described.

Figs. 6 to 8 are schematic views each showing a configuration example of the fixed foil trap 24.

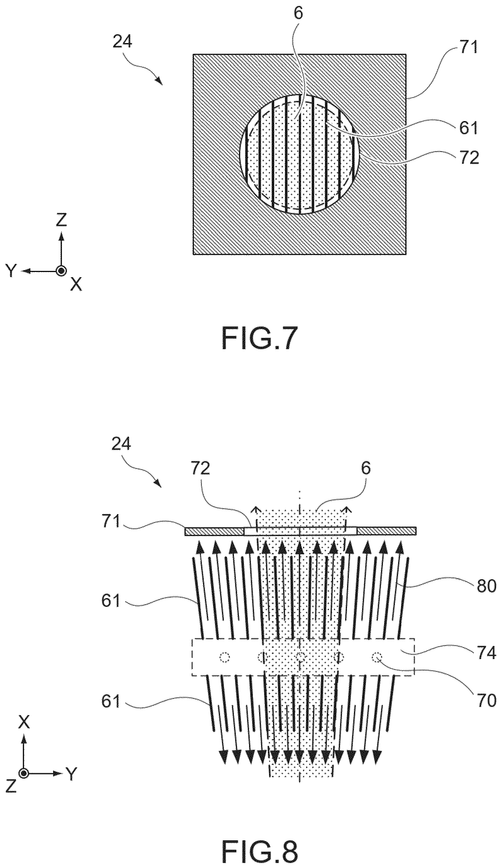

In Fig. 6, a state of a cross-section of the fixed foil trap 24 taken along a plane parallel to the XZ plane as viewed from the front side in Fig. 2 is shown. In Fig. 7, a state of the fixed foil trap 24 as viewed from the arrow A direction shown in Fig. 6 is shown. In Fig. 8, a state of a cross-section of the fixed foil trap 24 in the B-B surface of Fig. 6 as viewed from the upper side is shown. It should be noted that in Fig. 8, the illustration of the enclosure section 60 is omitted.

The fixed foil trap 24 further includes inflow holes 70 and a pressure adjustment plate 71. The inflow holes 70 are holes for introducing gas into the inner space 9 of the fixed foil trap 24. The inflow holes 70 are configured to communicate with the inner space 9 of the enclosure section 60. Specifically, five inflow holes 70 are arranged at equal intervals in the Y direction at positions, slightly shifted to the left (lower side in Fig. 8) of the upper surface (front surface in Fig. 8) and the lower surface (deep surface in Fig. 8) of the enclosure section 60 with respect to the respective centers. As a matter of course, specific configurations such as the number of inflow holes, positions, and the like of the inflow holes 70 are not limited. Moreover, the gas supply to the inflow holes 70 is performed by, for example, a gas supply means whose illustration is omitted in Fig. 2, via a gas piping (not shown) that couples the gas supply means and the inflow holes 70 to each other. It should be noted that in a case where the gas supply means is disposed outside the connection chamber21, such a gas piping is introduced into the connection chamber 21 from the gas supply means via the feedthroughs provided in the connection chamber 21 so as not to break the pressure atmosphere (pressure-reduced atmosphere) in the connection chamber.

In the present embodiment, argon (Ar) gas 80 is introduced by the inflow holes 70. For example, the control unit 12 controls the operation of a mechanism (not shown) (e.g., the above-mentioned gas supply means) for introducing the argon gas 80. The argon gas 80 is transparent gas transparent to the EUV light 6. That is, the argon gas 80 does not block the traveling of the EUV light 6 (e.g., reflection and refraction of the EUV light 6 do not occur). It should be noted that another kind of transparent gas such as helium (He) hydrogen (H₂) may be introduced.

The pressure adjustment plate 71 is a member that increases the pressure of the inner space 9. The pressure adjustment plate 71 has a plate shape and includes a circular opening 72 at the center. The pressure adjustment plate 71 is fitted in the entire emission port 63 of the enclosure section 60. That is, the emission port 63 is held in a state in which the pressure adjustment plate 71 seals a portion other than the opening 72. In this manner, the pressure adjustment plate 71 is disposed in the emission port 63 so that the opening area of the emission port 63 decreases.

Moreover, the shape of the opening 72 of the pressure adjustment plate 71 is set so as not to block the traveling of the EUV light 6. In the present embodiment, since the traveling region of the EUV light 6 at the position of the pressure adjustment plate 71 is circular as shown in Fig. 7, the shape of the opening 72 is set to be a circular shape having a slightly larger diameter than that of the traveling region of the EUV light 6. Accordingly, the pressure adjustment plate 71 does not block the traveling of the EUV light 6.

It should be noted that the EUV light 6 that travels inside the light source apparatus 1 can include EUV light 6 finally utilized by the utilization apparatus 42 and EUV light 6 not utilized by the utilization apparatus 42. In such a case, the pressure adjustment plate 71 only needs to be configured not to block the traveling of necessary light to be finally utilized. That is, the configuration not to block the traveling of the necessary light includes a configuration not to block the traveling of the EUV light 6 in the present technology.

A specific shape of the opening 72 of the pressure adjustment plate 71 is not limited. Any shape that does not block the traveling of the EUV light 6, e.g., a rectangular shape, may be employed. The pressure adjustment plate 71 corresponds to an embodiment of an emission side member and a lid member according to the present technology. Moreover, the pressure adjustment plate 71 realizes a pressure-increasing mechanism according to the present technology.

Moreover, each foil 61 includes an opening 73. As shown in Fig. 6, the opening 73 has a rectangular shape and is provided at the same position as the inflow holes 70 in the X direction at the center of the foil in the Z direction. That is, as shown in Fig. 8, the openings 73 form a buffer space 74 has a rectangular parallelepiped shape where the foil 61 does not exist. Each inflow hole 70 is in communication with the buffer space 74.

### [Configuration in Which Two Pressure Adjustment Plates are Provided]

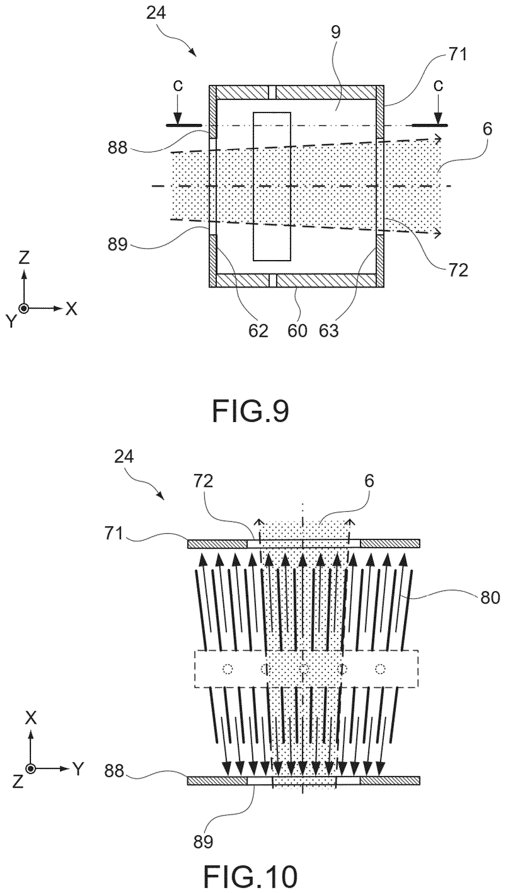

Figs. 9 and 10 are schematic views each showing a configuration example of the pressure adjustment plate.

Fig. 10 is a cross-sectional view of the fixed foil trap 24 along the C-C plane in Fig. 9. It should be noted that in Fig. 10, the illustration of the enclosure section 60 is omitted.

As shown in Figs. 9 and 10, a pressure adjustment plate may be provided in each of the incident port 62 and the emission port 63 of the enclosure section 60.

In this example, the fixed foil trap 24 further includes a pressure adjustment plate 88. The pressure adjustment plate 88 has a plate shape similar to the pressure adjustment plate 71 and includes a circular opening 89 at the center. The pressure adjustment plate 88 is fitted in the entire incident port 62 of the enclosure section 60. That is, a part of the incident port 62 other than the opening 89 is sealed with the pressure adjustment plate 88. In this manner, the pressure adjustment plate 88 is disposed in the incident port 62 so that the opening area of the incident port 62 decreases.

The shape of the opening 89 of the pressure adjustment plate 88 is set so as not to block the traveling of the EUV light 6 similarly to the shape of the opening 72 of the pressure adjustment plate 71. Although the shapes of the opening 72 and 89 are the same circular shape in this example, their shapes may be different from each other. The pressure adjustment plate 88 corresponds to an embodiment of an incident side member and the lid member according to the present technology. Moreover, the pressure adjustment plate 71 and the pressure adjustment plate 88 realize the pressure-increasing mechanism according to the present technology.

Alternatively, a configuration in which the pressure adjustment plate 88 is installed only in the incident port 62 without the pressure adjustment plate 71 being installed in the emission port 63 may be employed.

It is possible to increase the probability of capturing the debris DB by the argon gas 80 being introduced into the inner space 9 of the fixed foil trap 24. Specifically, in the space where the argon gas 80 is present, the collision of the debris DB and the argon gas 80 reduces the traveling speed of the debris DB. Moreover, the traveling direction of the debris DB changes due to the collision. The foils 61 and the enclosure section 60 capture the debris DB whose speed has decreased and whose traveling direction has changed in this manner. That is, a larger amount of debris DB is captured as compared to a case where the transparent gas is not introduced into the inner space 9 of the fixed foil trap 24.

Moreover, in the present embodiment, the inflow holes 70 for introducing the argon gas 80 are configured. Accordingly, it is possible to increase the pressure of the argon gas 80 in the inner space 9.

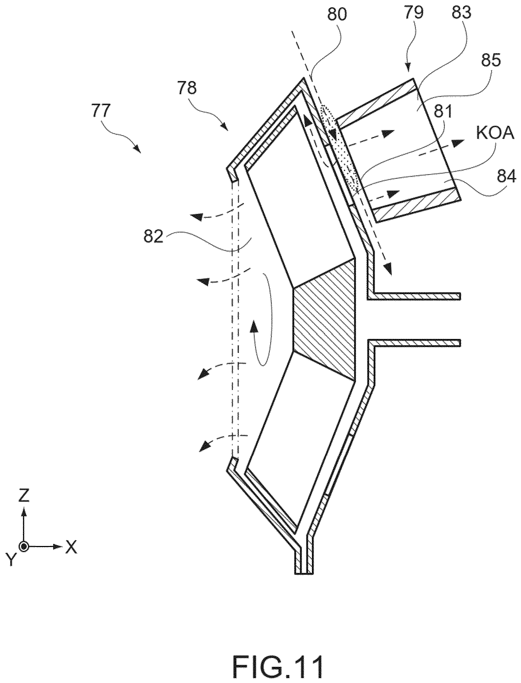

Fig. 11 is a schematic view showing a flow of the argon gas 80 in a debris reduction apparatus 77 according to a comparative example.

In the debris reduction apparatus 77 according to the comparative example, the argon gas 80 is introduced from the upper side of the gap between a rotary foil trap 78 and a fixed foil trap 79. In

Fig. 11, an orientation in which the introduced argon gas 80 diffuses is schematically shown as the dashed arrow.

The argon gas 80 is introduced by, for example, a gas nozzle (not shown). The argon gas 80 introduced from the upper side of the gap diffuses downward inside the gap. Due to the diffusion, the pressure of the argon gas 80 decreases in the lower portion of the gap. Thus, the upper portion of the gap is a region where the pressure of the argon gas 80 is relatively high. In Fig. 11, the region in which the pressure of the argon gas 80 is relatively high is shown in a dotted pattern.

The gap is in communication with an inner space 83 of the fixed foil trap 79. Therefore, the argon gas 80 enters the inner space 83 from an incident port 81 of the fixed foil trap 79 and diffuses in the inner space 83. However, the argon gas 80 located in the upper portion of the gap easily flows in the upper portion of the inner space 83 because of its high pressure. On the other hand, the argon gas 80 located in the lower portion of the gap does not easily flow in the lower portion of the inner space 83 because of its low pressure. Thus, the pressure of the argon gas 80 in the upper portion of the inner space 83 is relatively higher than that in the lower portion.

In this manner, a pressure difference of the argon gas 80 is generated also in the inner space 83. That is, a pressure distribution of the argon gas 80 in the traveling region of the EUV light 6 becomes uneven and a spatial distribution (unevenly) is caused in the capture capability of the debris DB in the fixed foil trap 79.

Moreover, the gap is in communication with the inner space 82 of the rotary foil trap 78. Therefore, the argon gas 80 enters the inner space 82 from the opening KOA of the rotary foil trap 78 and diffuses in the inner space 82.

In the fixed foil trap 79, the inner space 83 is divided by the respective foils 84. Therefore, the argon gas 80 relatively easily flows in the rotary foil trap 78 and does not relatively easily flow in the fixed foil trap 79. That is, a sufficient pressure of the argon gas 80 cannot be obtained in the fixed foil trap 79, and the capture capability of the debris DB cannot be enhanced.

In the debris reduction apparatus 3 of the present embodiment, the argon gas 80 is directly introduced into the inner space 9 of the fixed foil trap 24 through the inflow holes 70. Accordingly, the pressure distribution of the argon gas 80 does not become uneven in the inner space 9. Moreover, it is possible to keep the pressure of the argon gas 80 high in the inner space 9. That is, it is possible to enhance the probability of capturing the debris DB by the fixed foil trap 24.

Moreover, it is possible to increase the pressure of the argon gas 80 in the inner space 9 by the pressure adjustment plate 71 being disposed. In the fixed foil trap 79 according to the comparative example, the argon gas 80 that has flowed in diffuses rightwards in the inner space 83 and flows out of the emission port 85. On the other hand, in the fixed foil trap 24 according to the present embodiment, the pressure adjustment plate 71 seals a part of the emission port 63, so the flow-out of the argon gas 80 is suppressed. Thus, the pressure of the argon gas 80 in the inner space 9 increases.

In addition, due to the arrangement of the pressure adjustment plate 71, it is also possible to increase the pressure of the argon gas 80 in the rotary foil trap 22.

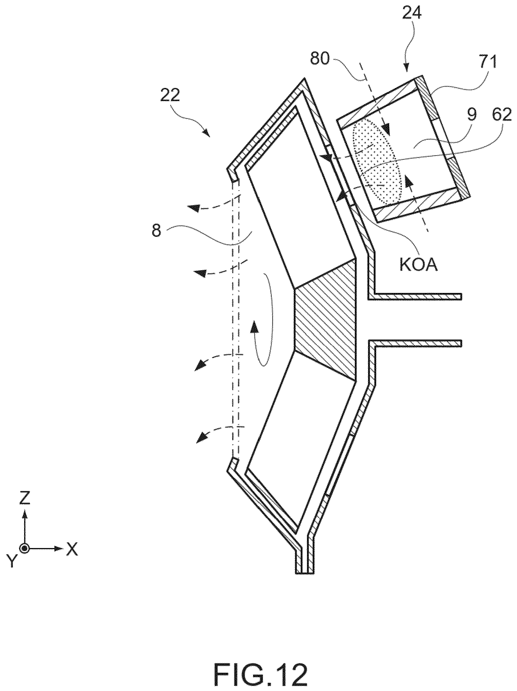

Fig. 12 is a schematic view showing a flow of the argon gas 80 in the debris reduction apparatus 3 according to the present technology.

The pressure adjustment plate 71 is disposed in the incident port 62 of the fixed foil trap 24 and the pressure adjustment plate 71 is disposed only in the emission port 63. Thus, the argon gas 80 introduced from the inflow holes 70 easily flows toward the incident port 62. Therefore, the vicinity of the incident port 62 in the inner space 9 serves as a region where the pressure of the argon gas 80 is relatively high. In Fig. 12, the region where the pressure of the argon gas 80 is relatively high is shown in a dotted pattern.

Therefore, the argon gas 80 that has flowed out of the incident port 62 due to a relatively high pressure enters the inner space 8 from the opening KOA of the rotary foil trap 22 as it is. Accordingly, the argon gas 80 is introduced also into the rotary foil trap 22, and the capture performance of the debris DB is further improved.

In a case where the two pressure adjustment plates 71 and 88 are provided, the argon gas 80 does not easily flow out of the incident port 62 and the pressure of the argon gas 80 in the inner space 9 further increases. That is, it is possible to further enhance the probability of capturing the debris DB.

Moreover, in the debris reduction apparatus 3 according to the present embodiment, the buffer space 74 is configured in the inner space 9 of the fixed foil trap 24. The argon gas 80 introduced from the inflow holes 70 first diffuses in the buffer space 74. Then, the argon gas 80 flows in the gap between the foils 61 located at the left and right of the buffer space 74 (vertically, X direction in Fig. 8). Then, the argon gas 80 diffuses in the X direction at the gap between the foils 61. In Fig. 8, an orientation in which the argon gas 80 diffuses at the gap between the foils 61 is schematically shown as the arrow.

The argon gas 80 first accumulates in the buffer space 74, and then flows in the gap between the foils 61 after the pressure has become uniform. Therefore, a difference is not easily caused in the pressure of the argon gas 80 at their gap. Due to the buffer space 74 configured, the pressure of the argon gas 80 becomes uniform in the inner space 9 in this manner, and the probability of capturing the debris DB is further enhanced.

Moreover, in the present embodiment, both the rotary foil trap 22 and the fixed foil trap 24 capture the debris. Accordingly, it is possible to cope with both the low-speed debris DB and the high-speed debris as compared to a case where only one of the rotary foil trap 22 or the fixed foil trap 24 is disposed, so the probability of capturing the debris DB is enhanced.

Moreover, in the present embodiment, the heat shield plate 23 is disposed between the plasma P and the rotary foil trap 22. By setting the shape of the opening KA of the heat shield plate 23 as appropriate, it is possible to arbitrarily change the shape of the EUV light 6 emitted from the light source apparatus 1. Moreover, it is possible to reduce the amount of debris DB that travels to the rotary foil trap 22. In addition, it is possible to prevent overheating of the rotary foil trap 22 and the like due to heat of the plasma P.

Hereinabove, in the debris reduction apparatus 3 according to the present embodiment, the plurality of foils 61 is disposed in the inner space 9 of the enclosure section 60. Moreover, the transparent gas flows in the inner space 9. In addition, the pressure adjustment plate 71 that increases the pressure of the inner space 9 is disposed. Accordingly, it is possible to enhance the probability of capturing the debris DB.

The EUV light source apparatus radiates extreme ultraviolet light (EUV light) of a wavelength of about 13.5 nm. Such EUV light is used for lithography in for example semiconductor device manufacture. Alternatively, blank test and pattern test of the mask are performed using the EUV light as test light. In this manner, the EUV light source apparatus is sometimes used for the mask test apparatus. Due to the use of the EUV light, it is possible to cope with a process of 5 nm to 7 nm.

However, the debris is radiated together with the EUV light in the EUV light source apparatus. When the debris reaches the utilization apparatus, the debris damages or contaminates the reflection film of an optical element in the utilization apparatus, which may lower the performance of the utilization apparatus. Therefore, in order to prevent the debris from entering the utilization apparatus, the debris reduction apparatus that captures the debris is incorporated in the EUV light source apparatus. In such a debris reduction apparatus, it is desirable to provide a technology of improving the debris capture performance.

In the debris reduction apparatus 3 according to the present technology, the pressure of the argon gas 80 in the inner space 9 increases due to the arrangement of the pressure adjustment plate 71. Accordingly, it is possible to realize high capture performance by the debris reduction apparatus 3.

### <Second Embodiment>

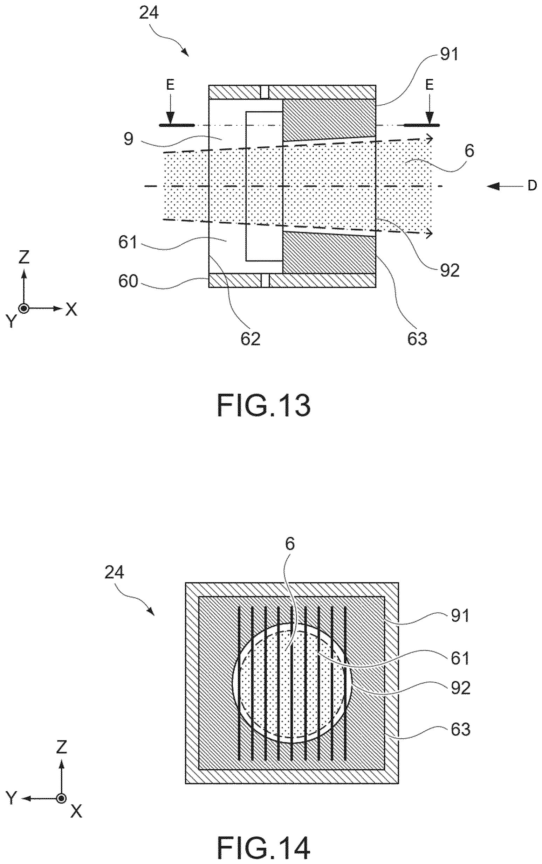

Referring to Figs. 13 to 15, a light source apparatus 1 according to a second embodiment of the present technology will be described. Hereinafter, descriptions of portions similar to the configurations and actions in the light source apparatus 1 described in the embodiment above will be omitted or simplified.

### [Cavity-Limiting Member]

Figs. 13 to 15 are schematic views each showing a configuration example of a cavity-limiting member.

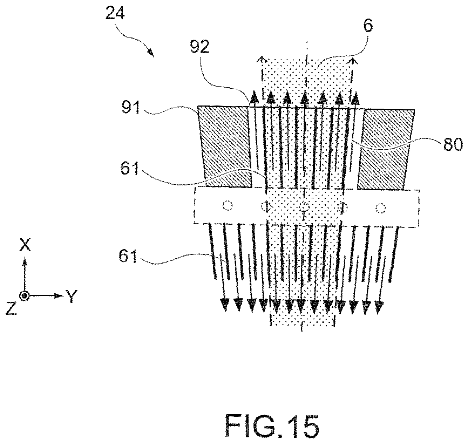

In Fig. 14, a state of the fixed foil trap 24 as viewed from the arrow D direction shown in Fig. 13 is shown. Fig. 15 is a cross-sectional view of the fixed foil trap 24 along the E-E plane in Fig. 13. It should be noted that the illustration of the enclosure section 60 is omitted in Fig. 15.

As shown in Figs. 13 to 15, the emission port 63 of the enclosure section 60 may be provided with the cavity-limiting member.

In this example, the fixed foil trap 24 includes a cavity-limiting member 91. The cavity-limiting member 91 has a block-like shape. Specifically, the cavity-limiting member 91 has a substantially rectangular parallelepiped shape. Moreover, the cavity-limiting member 91 includes an opening 92. The opening 92 is configured to communicate with two opposite surfaces of the cavity-limiting member 91. The shape of the opening 92 is set not to block the traveling of the EUV light 6 similarly to the shape of the opening 72 of the pressure adjustment plate 71.

The cavity-limiting member 91 is disposed in the emission port 63 of the enclosure section 60. Specifically, the cavity-limiting member 91 is embedded in the inner space 9 of the enclosure section 60 so that the opening 92 faces the emission port 63. That is, the cavity-limiting member 91 is disposed to fill the inner space 9. It should be noted that a specific shape of the cavity-limiting member 91 is not limited, and any shape such as a block shape may be employed. For example, the shape of the cavity-limiting member 91 is set as appropriate in accordance with the shape of the enclosure section 60 so that the cavity-limiting member 91 can be embedded in the enclosure section 60 with no gap. Moreover, specific thickness and the like of the cavity-limiting member 91 are not limited.

A groove portion is configured in the cavity-limiting member 91 and the foils 61 are fitted in the groove portion. In Fig. 14, a state in which the foils 61 are fitted in the groove portion is schematically shown. In a region of the inner space 9 where the cavity-limiting member 91 is present, the foils 61 are fixed to the cavity-limiting member 91 in this manner. It should be noted that in the region where the cavity-limiting member 91 does not exist, the foils 61 are fixed to the enclosure section 60.

The arrangement of the cavity-limiting member 91 reduces the capacity of the inner space 9. Moreover, the argon gas 80 does not easily flow out of the emission port 63. Accordingly, it is possible to keep the pressure of the argon gas 80 in the fixed foil trap 24 higher.

The cavity-limiting member 91 can be considered to have a shape obtained by increasing the length of the opening 72 of the pressure adjustment plate 71 in the direction in which the gas flows. Therefore, the conductance of the cavity-limiting member 91 is smaller than the conductance of the opening 72 of the pressure adjustment plate 71 disposed in the emission port 63. Therefore, it is possible to increase the pressure of the argon gas 80 in the inner space 9 in a case where the cavity-limiting member 91 is disposed as described above as compared to a case where the pressure adjustment plate 71 is disposed in the emission port 63.

Any combination as follows may be employed as an arrangement configuration of the pressure adjustment plate 71 and the cavity-limiting member 91.
(1) No component is disposed in the incident port 62 and the pressure adjustment plate 71 is disposed in the emission port 63
(2) No component is disposed in the incident port 62 and the cavity-limiting member 91 is disposed in the emission port 63
(3) The pressure adjustment plate 88 is disposed in the incident port 62 and no component is disposed in the emission port 63
(4) The pressure adjustment plate 88 is disposed in the incident port 62 and the pressure adjustment plate 71 is disposed in the emission port 63
(5) The pressure adjustment plate 88 is disposed in the incident port 62 and the cavity-limiting member 91 is disposed in the emission port 63
(6) The cavity-limiting member 91 is disposed in the incident port 62 and no component is disposed in the emission port 63
(7) The cavity-limiting member 91 is disposed in the incident port 62 and the pressure adjustment plate 71 is disposed in the emission port 63
(8) The cavity-limiting member 91 is disposed in the incident port 62 and the cavity-limiting member 91 is disposed in the emission port 63

The cavity-limiting member 91 corresponds to an embodiment of an incident side member, an emission side member, and a block member according to the present technology. Moreover, the cavity-limiting member 91 realizes the pressure-increasing mechanism according to the present technology.

### <Other Embodiments>

The present technology is not limited to the above-mentioned embodiments, and various other embodiments can be realized.

### [Space Connection Member]

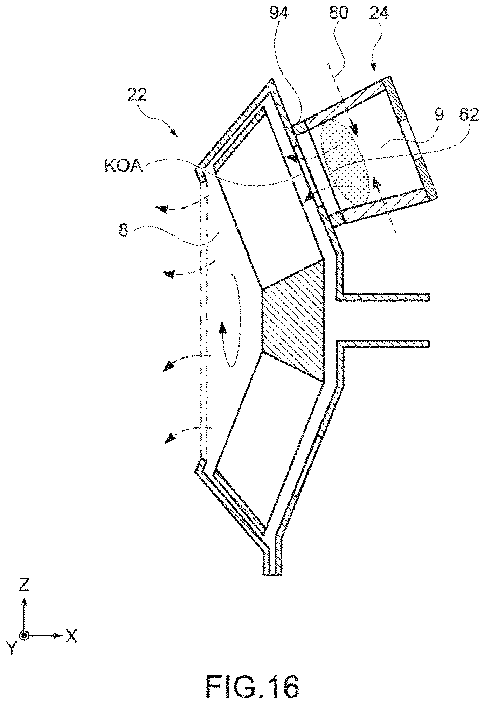

Fig. 16 is a schematic view showing a configuration example of a space connection member.

As shown in Fig. 16, a space connection member that connects the rotary foil trap 22 and the fixed foil trap 24 may be provided.

In this example, the debris reduction apparatus 3 includes a space connection member 94. The space connection member 94 has a ring shape, for example. Moreover, the diameter of the opening of the ring of the space connection member 94 is configured to have the same size as the diameter of the incident port 62 of the fixed foil trap 24.

The space connection member 94 is disposed so that the ring portion of the space connection member 94 seals the gap between the rotary foil trap 22 and the fixed foil trap 24. That is, the space connection member 94 couples the opening KOA of the rotary foil trap 22 and the incident port 62 of the fixed foil trap 24 to each other.

Accordingly, all the argon gas 80 that has flowed out of the incident port 62 of the fixed foil trap 24 flows in the rotary foil trap 22 without leaking out upwards and downwards in the gap. That is, it is possible to further increase the pressure of the argon gas 80 in the inner space 8 of the rotary foil trap 22. The space connection member 94 corresponds to an embodiment of a coupling member according to the present technology.

### [Front Closing Section]

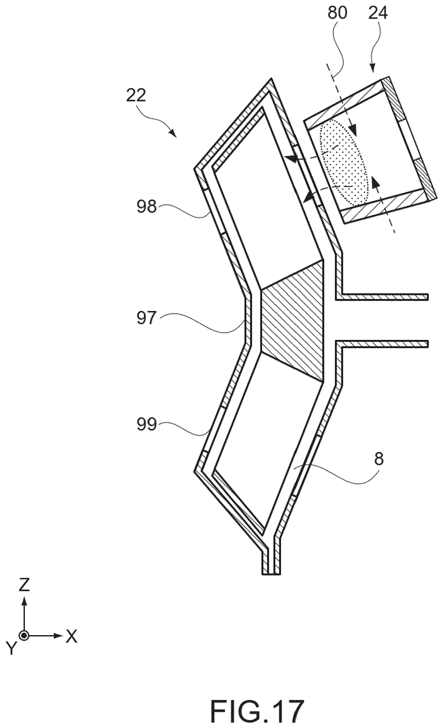

Fig. 17 is a schematic view showing a configuration example of a front closing section.

As shown in Fig. 17, the rotary foil trap 22 may be provided with the front closing section.

In this example, the rotary foil trap 22 further includes a front closing section 97. The front closing section 97 is configured so that the opening KI on the left side of the cover member 25 is sealed. That is, the front closing section 97 can also be considered as a part of the cover member 25. The front closing section 97 has a plate shape circular as viewed from the left side and has a shape protruding rightwards as it approaches the center of the circular shape.

Openings 98 and 99 are configured in the front closing section 97. The opening 98 has a circular shape and is disposed on the positive side in the Z direction at the center of the front closing section 97 in the Y direction. The opening 99 has a circular shape and is disposed on the negative side in the Z direction at the center of the front closing section 97 in the Y direction. Specific shape and position of the openings 98 and 99 are not limited.

Accordingly, a large part of the opening KI of the cover member 25 is sealed, which can suppress the argon gas 80 that has flowed in the rotary foil trap 22 from the fixed foil trap 24 from flowing out of the opening Kl. That is, it is possible to keep the pressure of the argon gas 80 high in the rotary foil trap 22.

It should be noted that the front closing section 97 is disposed in the opening KI so that the opening area of the opening KI decreases. Thus, the front closing section 97 can also be considered as the pressure adjustment plate 71 disposed in the rotary foil trap 22. Similarly, the right surface of the cover member 25 can also be considered as the pressure adjustment plate 71. Alternatively, the cavity-limiting member 91 may be disposed in the opening KI or the right surface of the cover member 25.

The front closing section 97 corresponds to an embodiment of the incident side member and the lid member according to the present technology. Moreover, the front closing section 97 realizes the pressure-increasing mechanism according to the present technology.

### [Addition of Fixed Foil Trap]

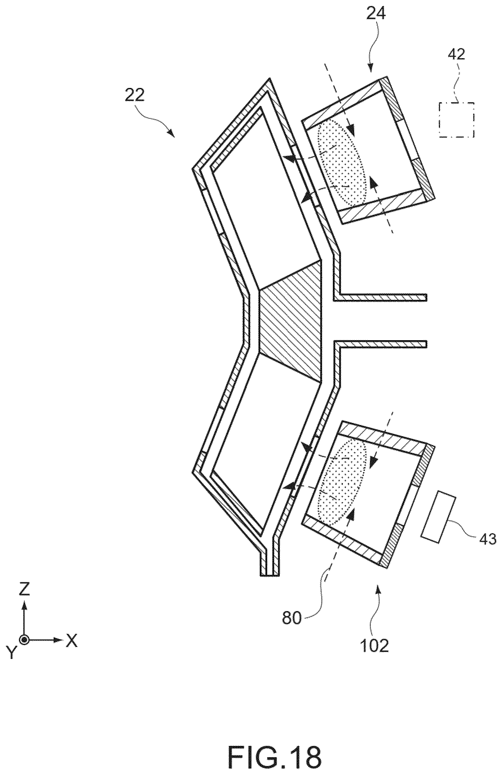

Fig. 18 is a schematic view showing a configuration example in which the fixed foil trap 24 is disposed between the rotary foil trap 22 and the monitor apparatus 43.

As shown in Fig. 18, the fixed foil trap 24 may be added between the rotary foil trap 22 and the monitor apparatus 43.

In this example, the debris reduction apparatus 3 includes fixed foil traps 24 and 102. The fixed foil trap 24 is disposed between the rotary foil trap 22 and the utilization apparatus 42 similarly to the fixed foil trap 24 shown in Fig. 1 and the like. The fixed foil trap 24 is disposed between the rotary foil trap 22 and the monitor apparatus 43. That is, it can also be said that the fixed foil traps 24 and 102 are respectively disposed between the plasma P and the utilization apparatus 42 and between the plasma P and the monitor apparatus 43.

Accordingly, the fixed foil trap 102 captures the debris DB, which suppresses the traveling of the debris DB to the monitor apparatus 43. That is, it is possible to prevent damages of the monitor apparatus 43 due to the collision of the debris DB. Moreover, since the argon gas 80 introduced into the fixed foil trap 102 flows in the rotary foil trap 22, it is possible to further increase the pressure of the argon gas 80 in the rotary foil trap 22.

### [Magnetic Field Application Means]

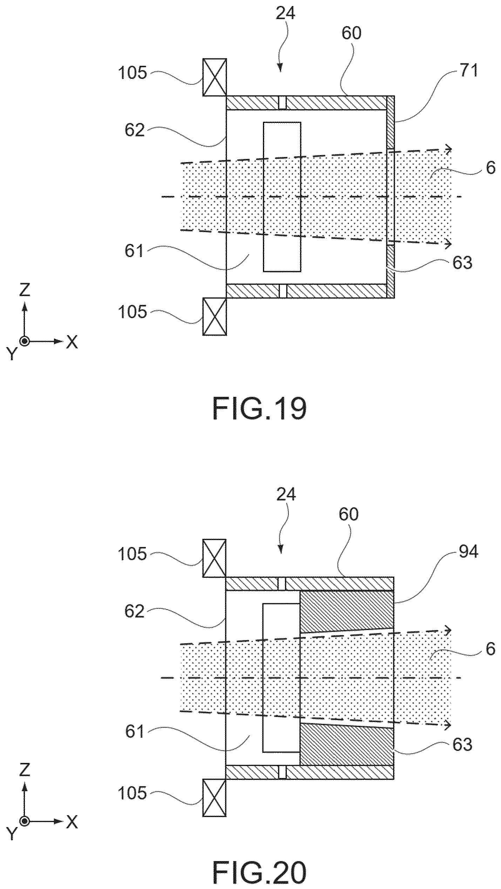

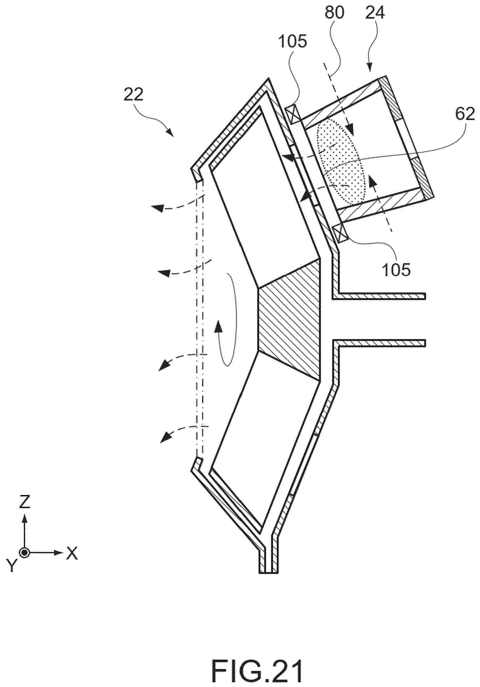

Figs. 19 to 21 are schematic views each showing a configuration example of a magnetic field application means.

In Fig. 19, a state in which a magnetic field application means 105 is provided in the fixed foil trap 24 with the pressure adjustment plate 71 disposed in the emission port 63 is shown. In Fig. 20, a state in which the magnetic field application means 105 is provided in the fixed foil trap 24 with the cavity-limiting member 91 disposed in the emission port 63 is shown.

As shown in Figs. 19 to 21, the magnetic field application means that applies a magnetic field may be provided in the fixed foil trap 24.

In this example, the fixed foil trap 24 includes the magnetic field application means 105. The magnetic field application means 105 is a means that applies a magnetic field to the surrounding space. For example, the permanent magnet and the like are used as the magnetic field application means 105. The magnetic field application means 105 is disposed in the upper portion and the lower portion of the incident port 62 of the enclosure section 60.

The magnetic field application means 105 generates a magnetic field that moves charged particles of particles contained in the argon gas 80, which are excited by the EUV light 6 in a direction away from the plurality of foils 61. That is, although the charged particles travel in various orientations between the foils 61, for example, the traveling directions of the charged particles change into the left orientations due to the applied magnetic field. In this case, the charged particles pass through the incident port 62 and move to the outside of the fixed foil trap 24. That is, the charged particles move in the direction away from the foils 61.

Alternatively, a magnetic field to change the traveling directions of the charged particles into right orientations and move the charged particles to the outside of the fixed foil trap 24 from the emission port 63 may be applied. For example, by setting the type of magnetic field application means 105 (permanent magnet, electromagnet, and the like), the positions or the number of magnetic field application means as appropriate, it is possible to adjust the orientation and intensity of the magnetic field.

The inventor has confirmed that in particular, the foils 61 of the fixed foil trap 24 are partially damaged along with the progress of the operation of the light source apparatus 1. Such damages can be considered to be caused by the debris DB which are high-energy particles (e.g., ions, electrons and the like of the plasma raw material SA moving at a high speed) colliding with the foils 61. However, it is conceivable that a large part of the debris DB with high energy that travels at such a high speed becomes neutral particles by colliding with the argon gas 80 whose pressure is relatively high before colliding with the foils 61 and the energy of the debris DB decreases. Therefore, the main cause of the damages of the foils 61 is not only the collision of the foils 61 and the debris DB.

Here, examining damage positions in the foils 61, it has been confirmed that damages of the foils 61 are frequent in particular a region where the pressure (density) of the argon gas 80 is relatively high and which is near a region through which the EUV light 6 passes. Based on this tendency, it is estimated that regarding damages of the foils 61, at least part of the argon gas 80 was excited by irradiation with the EUV light 6 and became charged particles with relatively high energy and the foils 61 were damaged by the contact of the charged particles of this argon and the foils 61.

In this example, the magnetic field application means 105 is provided so that the magnetic field is applied in a region in vicinity of the incident port 62 which is a region whose pressure (density) of the argon gas 80 is relatively high. Accordingly, the charged particles that collide with the foils 61 decrease and damages of the foils 61 are suppressed.

It should be noted that an electric field application means that generates an electric field that moves the charged particles in the direction away from the plurality of foils 61 may be provided. Due to the provision of the electric field application means, it is possible to suppress damages of the foils 61 similarly. The magnetic field application means 105 and the electric field application means correspond to an embodiment of an electromagnetic field generation unit according to the present technology.

### [Position of Buffer Space]

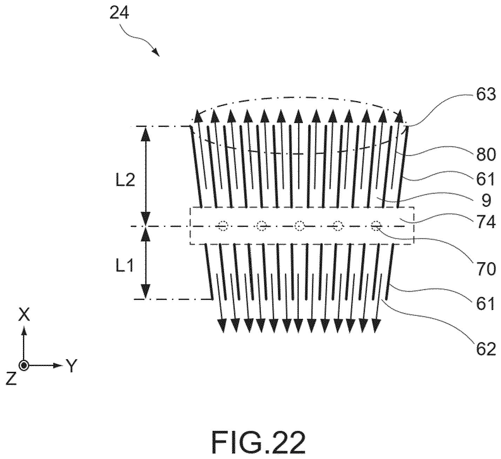

Fig. 22 is a schematic view showing a configuration example of the buffer space 74. It should be noted that the illustration of the enclosure section 60 is omitted in Fig. 22.

The position of the buffer space 74 may be arbitrarily set.

In this example, the buffer space 74 is configured so that the center of the buffer space 74 in the left and right directions (upper and lower directions in Fig. 22) becomes a position spaced away from a left end of the foils 61 (lower end in Fig. 22) by a distance L1 and spaced away from a right end (upper end in Fig. 22) by a distance L2. Here, L1 is a value smaller than L2. That is, the buffer space 74 is configured on the left side (lower side in Fig. 22) with respect to the center of the inner space 9.

The foils 61 are radially arranged to extend in a light beam direction of the EUV light 6 and the space between the foils 61 is narrow on the side of the incident port 62 of the EUV light 6 and wide on the side of the emission port 63. Therefore, the argon gas 80 supplied into the divided space of the foils 61 from the inflow holes 70 does not easily flow toward the incident port 62 and easily flows toward the emission port 63. Therefore, the pressure of the space in vicinity of the emission port 63 tends to be higher than the pressure of the space in vicinity of the incident port 62. In view of this, the attenuation of the intensity of the EUV light 6 due to the argon gas 80 cannot be ignored depending on a case.

Here, by setting the position of the buffer space 74 to be closer to the incident port 62 (i.e., setting L1 < L2), the pressure of the argon gas 80 in the space on the downstream side (right side) in the region through which the EUV light 6 passes can be made relatively low. In Fig. 22, the region whose pressure is relatively low is shown as a dashed ellipse. Accordingly, the optical path length in the space whose pressure of the argon gas 80 is high decreases, and it is possible to suppress the attenuation of the intensity of the EUV light 6 due to the argon gas 80. It should be noted that not limited to this example, the buffer space 74 may be configured at any position.

### [Configuration of Debris Reduction Apparatus]

A configuration in which only the fixed foil trap 24 is disposed while the rotary foil trap 22 is not disposed may be employed as a configuration of the debris reduction apparatus 3. As a matter of course, a configuration in which the rotary foil trap 22 and the fixed foil trap 24 are both disposed as shown in Fig. 1 may be employed. Alternatively, a plurality of rotary foil traps 22 and/or a plurality of fixed foil traps 24 may be disposed.

The configurations and the like of the light source apparatus, the light source section, the debris reduction apparatus, the rotary foil trap, and the fixed foil trap described with reference to the drawings are merely embodiments and can be arbitrarily modified without departing from the gist of the present technology. That is, any other configurations and the like for carrying out the present technology may be employed.

In the present disclosure, when the term "approximately" is used, it is used merely for easy understanding of the description and the use/non-use of the word "approximately" does not have special meaning. That is, in the present disclosure, it is assumed that concepts defining shape, size, positional relationship, state, and the like, such as "center," "middle," "uniform," "equal," "same," "orthogonal," "parallel," "symmetric," "extending," "axial direction," "columnar shape," "cylindrical shape," "ring shape," "annular shape," "rectangular parallelepiped shape," "disk shape," "plate shape," "circular shape," "rectangular shape," "oblong shape," "square shape," "block-like shape," are concepts including "substantially center," "substantially middle," "substantially uniform," "substantially equal," "substantially same," "substantially orthogonal," "substantially parallel," "substantially symmetric," "substantially extending," "substantially axial direction," "substantially columnar shape," "substantially cylindrical shape," "substantially ring shape," "substantially annular shape," "substantially rectangular parallelepiped shape," "substantially disk shape," "substantially plate shape," "substantially circular shape," "substantially rectangular shape," "substantially oblong shape," "substantially square shape," "substantially block-like shape," and the like. For example, they also include states within a predetermined range (e.g., a range of 0%) based on "perfectly center," "perfectly middle," "perfectly uniform," "perfectly equal," "perfectly same," "perfectly orthogonal," "perfectly parallel," "perfectly symmetric," "perfectly extending," "perfectly axial direction," "perfectly columnar shape," "perfectly cylindrical shape," "perfectly ring shape," "perfectly annular shape," "perfectly rectangular parallelepiped shape," "perfectly disk shape," "perfectly plate shape," "perfectly circular shape," "perfectly rectangular shape," "perfectly oblong shape," "perfectly square shape," "perfectly block-like shape," and the like. Thus, also in a case where the word "approximately" is not added, it can include a concept expressed with a so-called "approximately." On the contrary, a perfect state is not excluded as for the state expressed with "approximately."

In the present disclosure, the expressions including "than," such as "larger than A" and "smaller than A," are expressions comprehensively including both a concept including a case where it is equal to A and a concept not including a case where it is equal to A. For example, "larger than A" includes not only a case where it does not include equal to A, but also "equal to or larger than A." Moreover, "smaller than A" includes not only "smaller than A," but also "equal to or smaller than A." When carrying out the present technology, it is sufficient to employ specific settings and the like from the concepts included in "larger than A" and "smaller than A" as appropriate so that the above-mentioned effects can be provided.

At least two of the features of the present technology described above can also be combined. That is, the various features described in each embodiment may be arbitrarily combined without distinguishing the embodiments. Moreover, the various effects described above are merely exemplary, not limitative, and other effects may be provided.

### Reference Signs List

- DB: debris
- KA: opening
- KB: opening
- KI: opening
- KOA: opening
- KOB: opening
- P: plasma
- 1: light source apparatus
- 2: light source section
- 3: debris reduction apparatus
- 6: EUV light
- 8: inner space
- 9: inner space
- 22: rotary foil trap
- 23: heat shield plate
- 24: fixed foil trap
- 25: cover member
- 27: second window section
- 42: utilization apparatus
- 43: monitor apparatus
- 51: rotation foil
- 60: enclosure section
- 61: foil
- 62: incident port
- 63: emission port
- 70: inflow hole
- 71: pressure adjustment plate
- 74: buffer space
- 80: argon gas
- 88: pressure adjustment plate
- 89: opening
- 91: cavity-limiting member
- 92: opening
- 94: space connection member
- 97: front closing section
- 98: opening
- 99: opening
- 102: fixed foil trap
- 105: magnetic field application means

## Claims

1. A debris reduction apparatus that captures debris scattered from a light source, comprising
a fixed foil trap including
an enclosure section including an incident port that light emitted from the light source enters, an emission port from which the light that has entered from the incident port is emitted, and an inner space through which the light travels,
a plurality of foils that is fixed to a region of the inner space through which the light travels,
an inflow hole which is configured in the enclosure section to communicate with the inner space and in which transparent gas transparent to the light flows, and
a pressure-increasing mechanism including at least one of an incident side member that is disposed in the incident port so that an opening area of the incident port decreases without blocking traveling of the light or an emission side member that is disposed in the emission port so that an opening area of the emission port decreases without blocking traveling of the light, the pressure-increasing mechanism increasing a pressure of the inner space.

2. The debris reduction apparatus according to claim 1, wherein
at least one of the incident side member or the emission side member is a lid member that has a plate shape and includes an opening through which the light passes.

3. The debris reduction apparatus according to claim 1 or 2, wherein
at least one of the incident side member or the emission side member is a block member that has a block-like shape, includes an opening through which the light passes, and is disposed to fill the inner space.

4. The debris reduction apparatus according to claim 1 or 2, wherein
the fixed foil trap includes an electromagnetic field generation unit that generates an electric field or a magnetic field that moves charged particles excited by the light of particles contained in the transparent gas in a direction away from the plurality of foils.

5. The debris reduction apparatus according to claim 1 or 2, wherein
the inner space includes a buffer space where the plurality of foils does not exist, and the inflow hole is configured to communicate with the buffer space.

6. The debris reduction apparatus according to claim 1 or 2, wherein
the fixed foil trap is disposed between the light source and a utilization apparatus that utilizes the light emitted from the light source and between the light source and a monitor apparatus that monitors a state of the light emitted from the light source.

7. The debris reduction apparatus according to claim 1 or 2, wherein
the light source is a plasma.

8. The debris reduction apparatus according to claim 1 or 2, further comprising
a rotary foil trap including
a cover member including an incident port that the light emitted from the light source enters, an emission port from which the light that has entered from the incident port is emitted, and an inner space through which the light travels, and
a plurality of rotation foils rotatably attached to a region of the inner space through which the light travels.

9. The debris reduction apparatus according to claim 8, wherein
the rotary foil trap includes a pressure-increasing mechanism including at least one of an incident side member that is disposed in the incident port so that the opening area of the incident port decreases without blocking traveling of the light or an emission side member that is disposed in the emission port so that the opening area of the emission port decreases without blocking traveling of the light, the pressure-increasing mechanism increasing a pressure of the inner space.

10. The debris reduction apparatus according to claim 8, wherein
the fixed foil trap and the rotary foil trap are disposed at positions where the emission port of the rotary foil trap and the incident port of the fixed foil trap face each other, and
the debris reduction apparatus further includes a coupling member that couples the emission port of the rotary foil trap and the incident port of the fixed foil trap to each other.

11. The debris reduction apparatus according to claim 8, comprising
an aperture member that is disposed between the light source and the rotary foil trap and includes an opening that takes out part of the light emitted from the light source.

12. A light source apparatus, comprising:
a plasma generation chamber that excites a raw material that radiates light and generates plasma;
a light-taking out section that takes out light emitted from the plasma; and
a debris reduction apparatus that includes a fixed foil trap disposed between the plasma generation chamber and the light-taking out section and captures debris scattered from the plasma, wherein
the fixed foil trap includes
an enclosure section including an incident port that light emitted from the plasma enters, an emission port from which the light that has entered from the incident port is emitted, and an inner space through which the light travels,
a plurality of foils that is fixed to a region of the inner space through which the light travels, and
an inflow hole which is configured in the enclosure section to communicate with the inner space and in which transparent gas transparent to the light flows, and
a pressure-increasing mechanism including at least one of an incident side member that is disposed in the incident port so that the opening area of the incident port decreases without blocking traveling of the light or an emission side member that is disposed in the emission port so that the opening area of the emission port decreases without blocking traveling of the light, the pressure-increasing mechanism increasing a pressure of the inner space.

13. The light source apparatus according to claim 12, wherein
the debris reduction apparatus includes a rotary foil trap including
a cover member including an incident port that light emitted from the plasma enters, an emission port from which the light that has entered from the incident port is emitted, and an inner space through which the light travels, and
a plurality of rotation foils rotatably attached to a region of the inner space through which the light travels.
